# EUROPEAN PATENT APPLICATION

(11) **EP 4 571 820 A1**
(43) Date of publication of application: **18.06.2025**
(21) Application number: 22954928.2
(22) Date of filing: 09.08.2022
(51) Int. Cl.: H01L 21/338, H01L 29/778, H01L 29/812

(54) **SEMICONDUCTOR DEVICE AND PRODUCTION METHOD THEREFOR**

(71) Applicant: Tohoku University, Sendai-shi, Miyagi 980-8577 (JP)
(72) Inventor: MATSUOKA, Takashi, Sendai-shi, Miyagi 980-8577 (JP); SUEMITSU, Tetsuya, Sendai-shi, Miyagi 980-8577 (JP)
(74) Representative: Samson & Partner Patentanwälte mbB
(86) International application number: PCT/JP2022/030399
(87) International publication number: WO 2024/034007

(57) **Abstract**

In a first step S101, a first region in which a polarity inversion layer is formed, and a second region in which the polarity inversion layer is not formed are provided on a substrate. Next, in a second step S102, a first nitride semiconductor is epitaxially grown on the substrate having the first region and the second region along the c-axis direction such that a first semiconductor layer is formed. Next, in a third step S103, a second nitride semiconductor is epitaxially grown on the first semiconductor layer along the c-axis direction such that a second semiconductor layer is formed on the first semiconductor layer. The second nitride semiconductor has different polarization, electron affinity, and band-gap energy from the first nitride semiconductor. The second semiconductor layer forms a heterojunction with the first semiconductor layer. The interface therebetween has a polarization charge, which is positive or negative depending on polarity.

## Description

### TECHNICAL FIELD

The present invention relates to a semiconductor device comprising a nitride semiconductor and a manufacturing method thereof.

### BACKGROUND ART

Nitride semiconductors, such as GaN, have wide band-gaps, high breakdown electric fields, high saturation electron velocities, high thermal stability, and are used as materials for power devices that are resistant to high temperatures, have high output-power, and are resistant to high voltage, and have excellent high-frequency characteristics. Currently, application of power devices comprising nitride semiconductors to power control is rapidly increasing. Meanwhile, complementary MOSFET logic (CMOS) circuits comprising Si semiconductors are currently used for gate control of this type of power devices. However, it is ideal that gate control circuits also are constituted by nitride semiconductors from the viewpoint of thermal resistance and monolithic integration of the entire device.

### PRIOR ART DOCUMENTS

Non-Patent Document 1: N. Chowdhury et al., "Regrowth-free GaN-based Complementary Logic on a Si Substrate", IEEE Electron Device Letters, vol. 41, Issue 6, pp. 820-823, 2020.
Non-Patent Document 2: A. Nakajima et al., "GaN-based complementary metal-oxide-semiconductor inverter with normally off Pch and Nch MOSFETs fabricated using polarisation-induced holes and electron channels", IET Power Electron, vol. 11, Issue 4, pp. 689-694, 2018.

### SUMMARY OF THE INVENTION

However, in manufacturing transistors constituted by nitride semiconductors, dopants are introduced in the process of epitaxial crystal growth such as in metal-organic vapor phase epitaxy (MOVPE) technique, and therefore complex processes are essential for forming regions with different types of doping in the plane direction of the formed layer and for forming regions with different doping densities.

For example, when a CMOS is fabricated using a nitride semiconductor, a predetermined layer of nitride semiconductor for forming an n-type MOSFET and a predetermined layer of nitride semiconductor for forming a p-type MOSFET are epitaxially grown sequentially. Next, a p-type MOSFET is fabricated using a layer on the surface side for forming a p-type MOSFET. Next, in areas where the n-type MOSFET is formed, the layer for forming the p-type MOSFET is removed such that an n-type MOSFET is fabricated. Thus, prior art requires a complex process to fabricate a CMOS circuit (Non-Patent Document 1 and Non-Patent Document 2). In other words, the fabrication of CMOS circuits consisting of nitride semiconductors of prior art is not easy.

The present invention solves problems such as the aforementioned problems, and it aims to manufacture a CMOS circuit comprising a nitride semiconductor easily.

A method for manufacturing a semiconductor device according to the present invention comprises:
a first step of providing on a substrate a first region in which a polarity inversion layer is formed for reversing polarity between a state in which a crystal grows with Group-III polarity and a state in which a crystal grows with Group-V polarity, and a second region in which the polarity inversion layer is not formed;
a second step of crystal-growing a first nitride semiconductor on the substrate having the first region and the second region in a c-axis direction such that a first semiconductor layer is formed;
a third step of crystal-growing a second nitride semiconductor having different polarization, electron affinity, and band-gap energy from the first nitride semiconductor on the first semiconductor layer in the c-axis direction such that a second semiconductor layer forming a heterojunction with the first semiconductor layer is formed on the first semiconductor layer; and
a fourth step of forming a first field-effect-transistor of first electrical-conductivity type in the first region and a second field-effect-transistor of second electrical-conductivity type in the second region, by forming a gate electrode, a source electrode, and a drain electrode in each of the first region and the second region.

In a configuration example of the above-described method for manufacturing a semiconductor device, the polarity inversion layer is a layer formed by nitriding aluminum oxide.

In a configuration example of the above-described method for manufacturing a semiconductor device, the polarity inversion layer is a layer formed by oxidizing aluminum nitride.

In a configuration example of the above-described method for manufacturing a semiconductor device, the first field-effect-transistor of p-type is formed in the first region and the second field-effect-transistor of n-type is formed in the second region.

In a configuration example of the above-described method for manufacturing a semiconductor device, the first field-effect-transistor of n-type is formed in the first region and the second field-effect-transistor of p-type is formed in the second region.

A semiconductor device according to the present invention comprises:
a substrate having thereon a first region including a polarity inversion layer for reversing polarity between a state in which a crystal grows with Group-III polarity and a state in which a crystal grows with Group-V polarity, and a second region in which the polarity inversion layer is not formed on the substrate;
a first semiconductor layer which is constituted by a first nitride semiconductor epitaxially grown along a c-axis direction and which is formed on the substrate having the first region and the second region;
a second semiconductor layer which is constituted by a second nitride semiconductor epitaxially grown in the c-axis direction and having different polarization, electron affinity, and band gap from the first nitride semiconductor, the second semiconductor layer being formed on the first semiconductor layer and forming a heterojunction with the first semiconductor layer;
a first field-effect-transistor of first electrical-conductivity type including a gate electrode, a source electrode, and a drain electrode and being formed in the first region; and
a second field-effect-transistor of second electrical-conductivity type including a gate electrode, a source electrode, and a drain electrode and being formed in the second region.

In a configuration example of the above-described semiconductor device, the polarity inversion layer is a layer made by nitriding aluminum oxide.

In a configuration example of the above-described semiconductor device, the polarity inversion layer is a layer made by nitriding a surface of the substrate made of sapphire.

In a configuration example of the above-described semiconductor device, the polarity inversion layer is a layer made by nitriding an oxidized surface of the substrate made of AlN and having Group-III polarity.

In a configuration example of the above-described semiconductor device, the polarity inversion layer is a layer made by nitriding an oxidized surface of a layer made of AlN and having Group-III polarity, formed on the substrate made of GaN and having Group-III polarity.

In a configuration example of the above-described semiconductor device, the polarity inversion layer is a layer made by nitriding an oxidized surface of a layer of Group-III-polar AlN formed on the substrate made of hexagonal SiC is nitrided.

In a configuration example of the above-described method for manufacturing a semiconductor device, the polarity inversion layer is a layer made by oxidizing aluminum nitride is oxidized.

In a configuration example of the above-described semiconductor device, the polarity inversion layer is a layer made by oxidizing a nitrided surface of the substrate made of sapphire.

In a configuration example of the above-described semiconductor device, the polarity inversion layer is a layer made by oxidizing a surface of the substrate made of AlN and having N-polarity.

In a configuration example of the above-described semiconductor device, the polarity inversion layer is a layer made by oxidizing a surface of a layer made of AlN, having N-polarity, and formed on the substrate made of GaN and having N-polarity.

In a configuration example of the above-described semiconductor device, the polarity inversion layer is a layer made by oxidizing a layer made of AlN, having N-polarity, and formed on the substrate made of hexagonal SiC having C-polarity.

In a configuration example of the above-described semiconductor device, the first field-effect-transistor of p-type is formed in the first region, and the second field-effect-transistor of n-type is formed in the second region.

In a configuration example of the above-described semiconductor device, the first field-effect-transistor of n-type is formed in the first region, and the second field-effect-transistor of p-type is formed in the second region.

As explained above, in accordance with the present invention, it is possible to manufacture a CMOS circuit using a nitride semiconductor easily since a first region in which a polarity inversion layer is formed and a second region in which the polarity inversion layer is not formed are provided.

### BRIEF DESCRIPTION OF THE DRAWINGS

FIG. 1 shows a flowchart illustrating a method for manufacturing a semiconductor device according to an embodiment of the present invention.
FIG. 2A shows a cross-sectional view illustrating a state of the semiconductor device in a halfway step for explaining the method for manufacturing the semiconductor device according to the embodiment of the present invention.
FIG. 2B shows a cross-sectional view illustrating a state of the semiconductor device in a halfway process for explaining the method for manufacturing the semiconductor device according to the embodiment of the present invention.
FIG. 2C shows a cross-sectional view illustrating a state of the semiconductor device in a halfway process for explaining the method for manufacturing the semiconductor device according to the embodiment of the present invention.
FIG. 2D shows a cross-sectional view illustrating a state of the semiconductor device in a halfway process for explaining the method for manufacturing the semiconductor device according to the embodiment of the present invention.
FIG. 2E shows a cross-sectional view illustrating a state of the semiconductor device in a halfway process for explaining the method for manufacturing the semiconductor device according to the embodiment of the present invention.
FIG. 2F shows a cross-sectional view illustrating a state of the semiconductor device in a halfway process for explaining the method for manufacturing the semiconductor device according to the embodiment of the present invention.
FIG. 2G shows a cross-sectional view illustrating a state of the semiconductor device in a halfway process for explaining the method for manufacturing the semiconductor device according to the embodiment of the present invention.
FIG. 2H shows a cross-sectional view illustrating a state of the semiconductor device in a halfway process for explaining the method for manufacturing the semiconductor device according to the embodiment of the present invention.

### DETAILED DESCRIPTION OF THE INVENTION

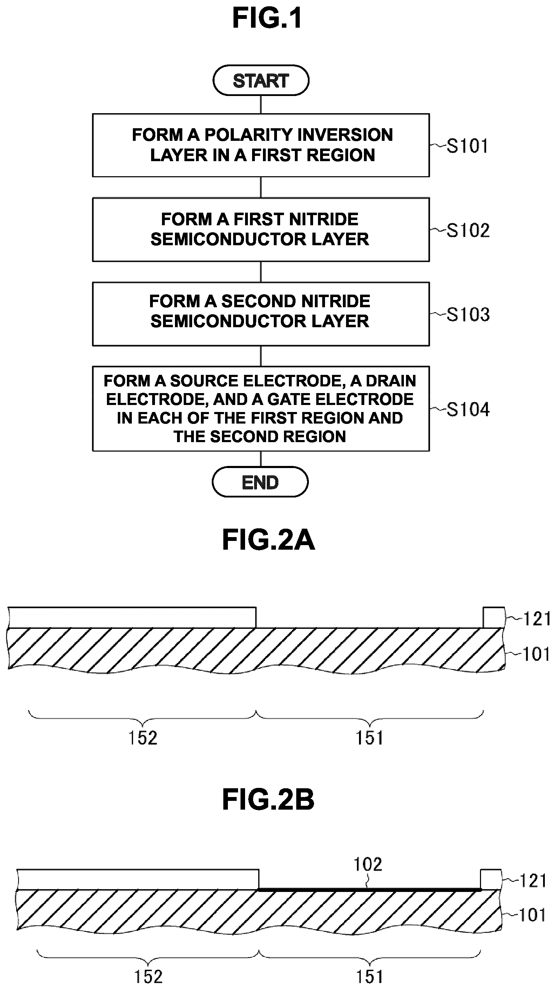

Hereinafter, the method for manufacturing a semiconductor device according to an embodiment of the present invention will be described with reference to FIG. 1.

First, in a first step S101, a first region in which a polarity inversion layer is formed and a second region in which the polarity inversion layer is not formed are provided on the substrate. The polarity inversion layer is a layer that reverses the polarity between a state in which a crystal grows with Group-III polarity (in a positive direction along the c-axis) and a state in which a crystal grows with Group-V polarity (in a negative direction along the c-axis) in a direction (growth direction) away from the crystal growth surface (main surface) of the substrate. Hereinafter, a nitride semiconductor grown with Group-III polarity in the growth direction is referred to as having Group-III polarity, and a nitride semiconductor grown with Group-V polarity in the growth direction is referred to as having Group-V polarity.

Next, in a second step S102, a first nitride semiconductor is epitaxially grown in the c-axis direction on a substrate having a first region and a second region such that a first semiconductor layer is formed. Next, in a third step S103, a second nitride semiconductor is epitaxially grown in the c-axis direction on the first semiconductor layer such that a second semiconductor layer is formed on the first semiconductor layer. The second nitride semiconductor has different electron affinity and band gap from the first nitride semiconductor, and the second semiconductor layer forms a heterojunction with the first semiconductor layer. The magnitude of polarization of the first nitride semiconductor and the second nitride semiconductor are different, and a polarization charge corresponding to the difference in polarization is generated at the heterojunction interface between the first semiconductor layer and the second semiconductor layer.

Next, in a fourth step S104, a gate electrode, a source electrode, and a drain electrode are formed in each of the first region and the second region. Thereby, a first field-effect-transistor of first electrical-conductivity type can be formed in the first region and a second field-effect-transistor of second electrical-conductivity type can be formed in the second region.

The method for manufacturing a semiconductor device according to the embodiment will now be described in more detail with reference to FIGS. 2A-2H.

First, as shown in FIG. 2A, a mask 121, which exposes the first region 151 but covers the second region 152, is formed on a substrate 101 constituted by sapphire. The mask 121 can be formed by, for example, depositing an insulating material, such as silicon oxide, on the substrate 101 to form an insulating film and patterning the insulating film thus formed by known lithography and etching techniques. The main surface of the substrate 101 is the C-plane of sapphire. As is well known, a nitride semiconductor usually is epitaxially grown with Group-III polarity on a substrate whose main surface made of sapphire, which is a non-polar crystal, is the C-plane.

Next, as shown in FIG. 2B, a polarity inversion layer 102 is formed on a region on the substrate 101 in the first region 151. This region is in an opened region on the mask 121. The polarity inversion layer 102 can be formed by nitriding the surface of the substrate 101 in the first region 151 by, for example, heating the substrate 101 to 950 to 1100°C in an ammonia atmosphere (it takes several minutes for this treatment).

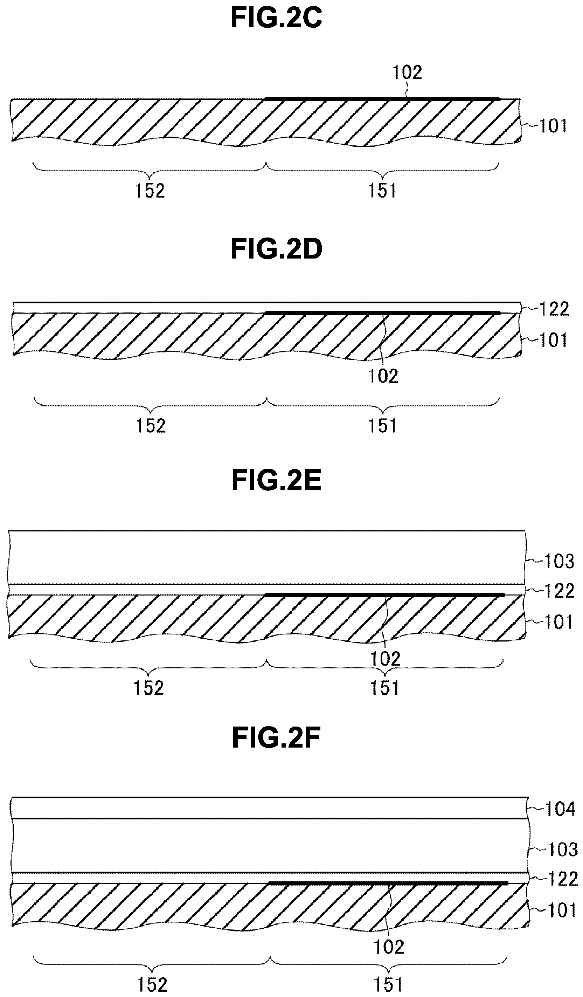

Next, the mask 121 is removed, and as shown in FIG. 2C, there are the first region 151 in which the polarity inversion layer 102 is formed on the substrate 101 and the second region 152 in which the polarity inversion layer is not formed (first step). For example, the mask 121 can be removed by etching treatment that uses hydrofluoric acid.

Next, as shown in FIG. 2D, a buffer layer 122 is formed on the substrate 101 having the first region 151 and the second region 152. The buffer layer 122 can be constituted by GaN. In addition to GaN, another nitride semiconductor such as AlN can also be used for the buffer layer 122.

A buffer layer 122 in which crystal regions are dispersed in a very small part of amorphous material is formed by, for example, growing GaN at a low temperature, such as about 500 to 800°C, using an MOVPE method that uses ammonia and triethylgallium (TEG) as raw materials. The buffer layer 122 can be formed to a thickness of about 20 to 50 nm. Moreover, by heating the buffer layer 122 to a higher temperature, a single crystal growth island is formed by solid phase growth. In this high-temperature treatment, the density of the growth islands in the buffer layer 122 is controlled together with the formation of the growth islands. Reducing the density has an effect of reducing dislocation density in the final single crystal.

At a phase where the buffer layer 122 described above is formed, each growth island has N-polarity (Group-V polarity) on the polarity inversion layer 102 in the first region 151, and each growth island has Group-III polarity in the second region 152.

Next, as shown in FIG. 2E, the first nitride semiconductor is epitaxially grown on the buffer layer 122 in the c-axis direction such that a first semiconductor layer 103 is formed. The first nitride semiconductor can be, for example, GaN. The first nitride semiconductor can be epitaxially grown using a known epitaxial growth technique of nitride semiconductors. The first nitride semiconductor is epitaxially grown above the polarity inversion layer 102 in the first region 151 in a negative direction along the c-axis such that it has N-polarity. Meanwhile, the first nitride semiconductor is epitaxially grown in the second region 152 in a positive direction along the c-axis such that it has Group-III polarity (second step).

Next, as shown in FIG. 2F, a second nitride semiconductor having electron affinity and band-gap energy different from the first nitride semiconductor is epitaxially grown on the first semiconductor layer 103 in the c-axis direction such that a second semiconductor layer 104 is formed. The second nitride semiconductor can be AlGaN. AlGaN is a nitride semiconductor with a smaller electron affinity and a wider band-gap than GaN. The second nitride semiconductor can be epitaxially grown by a known epitaxial growth technique of nitride semiconductors. The first semiconductor layer 103 and the second semiconductor layer 104 form a heterojunction. Moreover, the second nitride semiconductor is epitaxially grown above the polarity inversion layer 102 in the first region 151 in a negative direction along the c-axis such that it has N-polarity. Meanwhile, the second nitride semiconductor is epitaxially grown in the second region 152 in a positive direction along the c-axis such that it has Group-III polarity (third step).

The N-polar nitride semiconductor layer is polarized such that it has positive polarity at the upper side (surface side) and negative polarity at the lower side (substrate side). At the heterojunction interface where AlGaN is formed on GaN, a polarized charge corresponding to the difference between the positive charge appearing on the top surface of GaN and the negative charge appearing on the bottom surface of AlGaN is generated, and the polarized charge has a negative value because AlGaN has greater polarization among GaN and AlGaN. When holes exist as carriers in the crystal, they gather in the vicinity of the interface having the aforementioned negatively-polarized charge such that the holes form two-dimensional hole gas.

Meanwhile, the semiconductor layer with Group-III polarity is polarized such that it has negative polarity at the upper side (surface side) and positive polarity at the lower side (substrate side). At the heterojunction interface where AlGaN is formed on GaN, a polarized charge corresponding to the difference between the negative charge appearing on the top surface of GaN and the positive charge appearing on the bottom surface of AlGaN is generated, and the polarized charge has a positive value because AlGaN has a larger polarization among GaN and AlGaN. When electrons exist as carriers in the crystal, they gather in the vicinity of the interface having the aforementioned positively polarized electric field such that the electrons form two-dimensional electron gas.

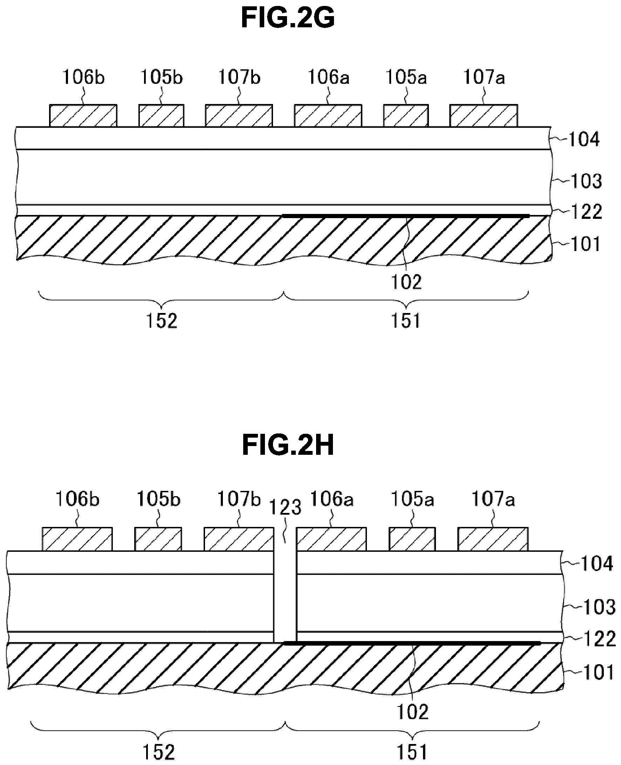

Next, as shown in FIG. 2G, a first gate electrode 105a, a first source electrode 106a, and a first drain electrode 107a are formed on the second semiconductor layer 104 in the first region 151. Moreover, a second gate electrode 105b, a second source electrode 106b, and a second drain electrode 107b are formed on the second semiconductor layer 104 in the second region 152.

Each gate electrode can be formed by etching a part of the second semiconductor layer 104. Moreover, each gate electrode can be formed by inserting another layer of insulating material, such as a silicon nitride film, on the second semiconductor layer 104. Each source electrode and each drain electrode can be formed by etching a part or all of the second semiconductor layer 104. Moreover, each source electrode and each drain electrode can be formed by inserting a layer of another material, such as a layer of Si-doped GaN, on the second semiconductor layer 104.

With the formation of each of the electrodes described above, a first field-effect-transistor of first electrical-conductivity type (p type: the channel is formed by two-dimensional hole gas) is formed in the first region 151, and a second field-effect-transistor of second electrical-conductivity type (n type: the channel is formed by two-dimensional electron gas) is formed in the second region 152. The first field-effect-transistor and the second field-effect-transistor are high electron mobility transistors (HEMT). Moreover, in the above-described example, the second semiconductor layer 104 functions as a layer referred to as a "barrier layer".

First, a positive polarization charge is generated at the heterojunction interface due to the polarization effect of the nitride semiconductor, in the heterojunction structure constituted by the first semiconductor layer 103 comprising GaN and the second semiconductor layer 104 comprising AlGaN in the second region 152 where the first semiconductor layer 103 and the second semiconductor layer 104 are formed of crystals with Group-III polarity. As a result, electrons are accumulated with high density in the vicinity of the heterojunction interface, forming two-dimensional electron gas. Therefore, in the aforementioned configuration, the field-effect-transistor formed in the second region 152 is of an n-type channeled by two-dimensional electron gas.

Meanwhile, in the first region 151, the first semiconductor layer 103 and the second semiconductor layer 104 are formed of N-polar crystals, and therefore a negative polarization charge is generated in the heterojunction structure between the first semiconductor layer 103 and the second semiconductor layer 104. As a result, holes accumulate at high density in the vicinity of the heterojunction interface, forming two-dimensional hole gas. For this reason, in the aforementioned configuration, the field-effect-transistor formed in the first region 151 is of a p-type channeled by the two-dimensional hole gas.

A semiconductor device according to the embodiment fabricated by the above-described process comprises:
a substrate 101 having a first region 151 including a polarity inversion layer 102 for reversing the polarity between a state in which the crystal is grown with Group-III polarity on the substrate 101 and a state in which the crystal is grown with Group-V polarity, and a second region 152 in which the polarity inversion layer 102 is not formed on the substrate 101;
a first semiconductor layer 103 which is constituted by a first nitride semiconductor epitaxially grown in the c-axis direction and which is formed on the substrate 101 having the first region 151 and the second region 152;
a second semiconductor layer 104 which is constituted by a second nitride semiconductor having electron affinity and band gap different from the first nitride semiconductor and epitaxially grown in the c-axis direction, which is formed on the first semiconductor layer 103, and which forms heterojunction with the first semiconductor layer 103;
a first field-effect-transistor of first electrical-conductivity type including a first gate electrode 105a, a first source electrode 106a, and a first drain electrode 107a formed in the first region 151; and
a second field-effect-transistor of second electrical-conductivity type including a second gate electrode 105b, a second source electrode 106b, and a second drain electrode 107b formed on the second semiconductor layer 104 in the second region 152.

The polarity inversion layer 102 can be a layer made by nitriding aluminum oxide. As will be described later, the polarity inversion layer 102 can be a layer made by oxidizing aluminum nitride.

As described above, by providing a first region 151 in which a polarity inversion layer 102 is formed and a second region 152 in which the polarity inversion layer 102 is not formed on the same substrate 101, it is possible to form a p-type field-effect-transistor and an n-type field-effect-transistor next to each other, enabling to configure a CMOS circuit.

As shown in FIG. 2H, an element separation structure 123 is formed at the boundary between the first region 151 and the second region 152 for element separation between a field-effect-transistor formed in the first region 151 and a field-effect-transistor formed in the second region 152. The element separation structure 123 can be, for example, a groove. The separation structure 123 can be formed after the respective electrodes are formed. The separation structure 123 can also be formed before the respective electrodes are formed.

Meanwhile, in many cases in common epitaxial growth of nitride semiconductors, residual donor density is 10¹⁶-10¹⁷ cm⁻³, which naturally becomes n-type. In order to make this a p-type and ensure holes with sufficient density, it is necessary to dope acceptor impurities not less than the residual donor density. In addition, the residual donor density tends to be different between the case where the growth with Group-III polarity was carried out and the case where N-polar growth was carried out.

In the above-described example, a p-type transistor, which grows with N-polarity, is formed in the first region 151, and an n-type transistor, which grows with Group-III polarity, is formed in the second region 152. For example, if the residual donor density is higher in Group-III-polar growth than in N-polar growth, it is possible to make the N-polar region p-type by doping an appropriate density of acceptor impurities during the crystal growth and maintain the Group-III-polar region n-type.

Meanwhile, for example, if the residual donor density is higher in N-polar growth than in the growth with Group-III polarity , it is difficult to maintain the N-polar growth side p-type and the Group-III-polar growth side n-type. Therefore, if the residual donor density is higher in N-polar growth than in the growth with Group-III polarity, the material is replaced in the first semiconductor layer and the second semiconductor layer such that material with greater polarization and band-gap energy and smaller electron affinity is used for the first semiconductor layer. By configuring in this way, it is possible to make the first region which have N-polarity and in which the residual donor density increases an n-type field-effect-transistor, and make the second region which have Group-III polarity a p-type field-effect-transistor.

In a heterojunction where a second semiconductor layer with a smaller polarization is formed on a first semiconductor layer with a larger polarization, high density electrons are accumulated in the vicinity of the heterojunction interface in the first region having N-polarity, forming two-dimensional electron gas. Meanwhile, in the second region having Group-III polarity, high density holes are accumulated in the vicinity of the heterojunction interface, forming two-dimensional hole gas.

As mentioned above, the electrical conductivity of nitride semiconductors is prone to n-type due to lattice defects, such as atomic vacancies, and impurities mixed in during the crystal growth. In the case of n-type, the acceptor is doped into the nitride semiconductor that is epitaxially grown to ensure sufficient density of holes. However, Mg, which can be used as an acceptor in nitride semiconductors, is the material that is prone to heat diffusion, and it is not easy to selectively dope Mg in some regions. Therefore, Mg is uniformly doped so as to have the residual donor density (10¹⁶-10¹⁷ cm⁻³) or more in all layers that grow crystals. This makes a large number of holes carriers. In a state where negative polarization charge is generated at the heterojunction interface, holes gather in the vicinity of the interface such that they form two-dimensional hole gas.

Next, the polarity inversion layer will be described. In the above-described example, a polarity inversion layer is formed by nitriding the surface of the substrate (sapphire substrate) in the first region made of sapphire. By observing this condition by transmission electron microscopy, it was confirmed that an extremely thin layer (< 5 nm) of N-polar AlN was formed. This indicates that a layer of N-polar AlN is formed by nitriding aluminum oxide.

Therefore, it is possible to form the first region and the second region on the sapphire substrate by, for example, nitriding the entire region of the sapphire substrate to form a layer of N-polar AlN on the entire region of the substrate surface, and then using a mask having openings and etching off the layer of N-polar AlN in the second region in the second region to expose the surface of the sapphire substrate. In this case, the layer of N-polar AlN that remains after the aforementioned selective etching can be a polarity inversion layer.

In addition, it is possible to form the first region and the second region on the sapphire substrate by, for example, nitriding the entire region of the sapphire substrate to form a layer of N-polar AlN on the entire region of the substrate surface, using a mask having openings in the second region, and oxidizing the layer of N-polar AlN in the second region to form an aluminum oxide layer on at least the surface of the AlN layer. The entire AlN layer can also be an aluminum oxide layer. In this case, the layer of N-polar AlN that remains without the aforementioned selective oxidation can be a polarity inversion layer. For example, the oxidation described above can be carried out by exposing to oxygen or a mixture gas of oxygen and water vapor at a high temperature of about 1000°C. The oxidation described above can also be achieved by exposure to oxygen plasma.

An aluminum oxide layer formed by selective oxidation can also be a polarity inversion layer. In this case, the openings on the mask are formed in the first region. When a polarity inversion layer having Group-III polarity is thus formed on a part of the layer having N-polarity, the HEMT formed in the first region becomes n-type, and the HEMT formed in the second region becomes p-type. Moreover, the inverted HEMT formed in the first region becomes p-type, and the inverted HEMT formed in the second region becomes n-type.

In addition, the first region and the second region can be formed on the N-polar AlN substrate by using a substrate made of AlN and having N-polarity (N-polar AlN substrate), using a mask having openings in the first region, and oxidizing the surface of the N-polar AlN substrate in the first region to form an aluminum oxide layer.

In this case, the aluminum oxide layer formed by partial oxidization can be a polarity inversion layer. When a polarity inversion layer having Group-III polarity is thus formed on a part of the substrate having N-polarity, the HEMT formed in the first region becomes n-type, and the HEMT formed in the second region becomes p-type. Moreover, the inverted HEMT formed in the first region becomes p-type, and the inverted HEMT formed in the second region becomes n-type.

In addition, the first region and the second region can be formed on the Group-III-polar AlN substrate by using a substrate made of AlN and having Group-III polarity (Group-III-polar AlN substrate), using a mask having openings in the first region, selectively oxidizing the surface of the Group-III-polar AlN substrate in the first region to form an aluminum oxide layer, and then selectively nitriding the aluminum oxide layer in the first region to form an AlN layer on at least the surface of the aluminum oxide layer. It should be noted that all layers of aluminum oxide can also be made of AlN. In this case, the aluminum oxide layer formed by partial oxidization is further nitrided to form an AlN layer having N-polarity, and therefore the AlN layer having N-polarity can be a polarity inversion layer.

A substrate made of GaN and having N-polarity (N-polar GaN substrate) can also be used. A mask having openings in the first region is formed on the N-polar GaN substrate such that AlN selectively epitaxially grows on the opening. The AlN layer thus grown on the opening on the mask is formed such that it has N-polarity. Subsequently, the AlN layer is oxidized to form an aluminum oxide layer on at least the surface of the AlN layer. Of course, the entire AlN layer can be an aluminum oxide layer. Subsequently, after removing the aforementioned mask, an aluminum oxide layer is formed in the first region of the N-polar GaN substrate but the surface of the N-polar GaN substrate is exposed in the second region.

As mentioned above, if a nitride semiconductor is epitaxially grown on an aluminum oxide layer, it grows having Group-III polarity. Meanwhile, if a nitride semiconductor is epitaxially grown on the surface of an N-polar GaN substrate, it grows having N-polarity. Therefore, in this case, the aluminum oxide layer formed in the first region can be a polarity inversion layer.

A substrate made of GaN and having Group-III polarity (Group-III-polar GaN substrate) can also be used. A mask having openings in the first region is formed on a Group-III-polar GaN substrate such that AlN selectively epitaxially grows on the opening. The AlN layer which is thus grown on the substrate surface and which is exposed on the opening on the mask is formed such that it has Group-III polarity.

Next, the AlN layer formed to have Group-III polarity is oxidized to form an aluminum oxide layer on at least the surface of the AlN layer. Of course, the entire AlN layer can also be an aluminum oxide layer. Then, an N-polar AlN layer is formed on the opening on the mask by selectively nitriding the aluminum oxide layer such that an AlN layer is formed on at least the surface of the aluminum oxide layer. Subsequently, after removing the aforementioned mask, an N-polar AlN layer is formed in the first region of the Group-III-polar GaN substrate but the surface of the Group-III-polar GaN substrate is exposed in the second region. Thus, a polarity inversion layer that is an N-polar AlN layer can be formed in the first region of the Group-III-polar GaN substrate.

In addition, the AlN layer formed by a usual crystal growth technique on any substrate such as a hexagonal (hexagonal close-packed structure) SiC substrate has Group-III polarity. In this case, by doing the same as the Group-III-polar AlN substrate described above, a part of the AlN layer having Group-III polarity can be an N-polar AlN layer, and this layer can be a polarity inversion layer. In this case, it is possible to increase the number of available substrate options.

In addition, an AlN layer epitaxially grown on any substrate such as a hexagonal SiC substrate having C-polarity has N-polarity. In this case, by using the same process as the N-polar AlN substrate described above, a part of the AlN layer having N-polarity can have Group-III polarity.

In the case where a polarity inversion layer is formed by a treatment such as aforementioned nitriding and oxidation of the substrate surface, it is not necessary to separately form a layer for the polarity inversion layer, and therefore the process can be simplified. Moreover, for example, the thickness of the AlN layer formed by nitriding by exposing the surface of the sapphire substrate to ammonia for about 5 minutes at a temperature of about 1000°C is about 2-3 nm or less. Since the oxygen atoms in Al₂O₃ constituting the sapphire substrate are replaced by N atoms by nitriding, there is substantially no difference in level due to the polarity inversion layer. This is also the case when an AlN layer is formed over the entire surface of the substrate and then a polarity inversion layer is formed. Meanwhile, when a GaN substrate is used, there may be a difference in level due to the formed polarity inversion layer.

In addition, Si having a diamond structure can be used for the substrate. In this case, the orientation of the crystal surface is {111}. When growing a nitride semiconductor on a Si substrate, formation of an AlN layer has been achieved so far. This is because, when one tries to directly grow a Ga-containing material, such as GaN, on a Si substrate, Ga melts Si in the vicinity of the substrate surface, and therefore it is not possible to obtain a good crystal.

Therefore, when using a Si substrate, AlN is first grown on the Si substrate to form an AlN layer. The AlN layer thus formed has Group-III polarity. Therefore, in the same manner as in the aforementioned case of using an AlN substrate having Group-III polarity or the case using an AlN layer having Group-III polarity, an N-polar nitride semiconductor layer and a Group-III-polar nitride semiconductor layer can be formed monolithically on the same Si substrate using a polarity inversion layer.

In addition, ScAlMgO₄ can be used for the substrate instead of sapphire. For example, the lattice mismatch with GaN in a ScAlMgO₄ crystal is -1.9%, which is very small compared with 13.8% in the case of sapphire. Therefore, the quality of the crystal in the resulting nitride semiconductor layer can be improved.

Moreover, as described above, a first field-effect-transistor of first electrical-conductivity type can be formed in the first region, and a second field-effect-transistor of second electrical-conductivity type can be formed in the second region, and then a stacked structure constituted by various semiconductor layers can be formed thereon. Various semiconductor elements can be formed on the stacked structure. In addition, a stacked structure constituted by various semiconductor layers is formed on the substrate, and an AlN layer is formed thereon. A polarity inversion layer is formed in this situation such that a first region and a second region are formed. Similarly to the above, a first field-effect-transistor of first electrical-conductivity type can be formed in the first region, and a second field-effect-transistor of second electrical-conductivity type can be formed in the second region. Various semiconductor elements can be formed on the stacked structure.

As explained above, in accordance with the present invention, a first region in which a polarity inversion layer is formed and a second region in which the polarity inversion layer is not formed are provided, and therefore a CMOS circuit using a nitride semiconductor can be easily fabricated. In accordance with the present invention, a CMOS control circuit using a nitride semiconductor can be easily obtained, and unification and integration with a power device using nitride semiconductors can be realized extremely easily. As a result, for example, a power module for driving an electric motor to be used for an electric vehicle can be dramatically miniaturized and manufactured at a low cost.

In addition, transistors have been improving their performance by miniaturizing the size of the device, but in extremely miniaturized Si semiconductor devices, there are only a small number of doped impurity atoms for generating carriers. In such a situation, variations in the number of impurity atoms directly result in variations in device characteristics, and this is one of the factors that determine the limit of miniturization. Meanwhile, the polarization charge generated by the polarization effect of nitride semiconductors is much denser than the impurity doping density and is uniformly distributed even when miniturized, and therefore it is possible to miniturize furthermore.

The present invention should not be limited to the embodiments described above, and it is apparent that a person skilled in the art can implement many modifications and combinations within the technical concept of the present invention.

### REFERENCE SIGNS LIST

101: substrate
102: polarity inversion layer
103: first semiconductor layer
104: second semiconductor layer
105a: first gate electrode
105b: second gate electrode
106a: first source electrode
106b: second source electrode
107a: first drain electrode
107b: second drain electrode
121: mask
122: buffer layer
123: element isolation structure
151: first region
152: second region

## Claims

1. A method for manufacturing a semiconductor device, comprising:
a first step of providing on a substrate a first region in which a polarity inversion layer is formed for reversing polarity between a state in which a crystal grows with Group-III polarity and a state in which a crystal grows with Group-V polarity, and a second region in which the polarity inversion layer is not formed;
a second step of crystal-growing a first nitride semiconductor on the substrate having the first region and the second region in a c-axis direction such that a first semiconductor layer is formed;
a third step of crystal-growing a second nitride semiconductor having different polarization, electron affinity, and band gap from the first nitride semiconductor on the first semiconductor layer in the c-axis direction such that a second semiconductor layer forming a heterojunction with the first semiconductor layer is formed on the first semiconductor layer; and
a fourth step of forming a first field-effect-transistor of first electrical-conductivity type in the first region and a second field-effect-transistor of second electrical-conductivity type in the second region, by forming a gate electrode, a source electrode, and a drain electrode in each of the first region and the second region.

2. The method according to claim 1, wherein
the polarity inversion layer is a layer formed by nitriding aluminum oxide.

3. The method according to claim 1, wherein
the polarity inversion layer is a layer formed by oxidizing aluminum nitride.

4. The method according to any one of claims 1 to 3, wherein
the first field-effect-transistor of p-type is formed in the first region and the second field-effect-transistor of n-type is formed in the second region.

5. The method according to any one of claims 1 to 3, wherein
the first field-effect-transistor of n-type is formed in the first region and the second field-effect-transistor of p-type is formed in the second region.

6. A semiconductor device comprising:
a substrate having thereon a first region including a polarity inversion layer for reversing polarity between a state in which a crystal grows with Group-III polarity and a state in which a crystal grows with Group-V polarity, and a second region in which the polarity inversion layer is not formed on the substrate;
a first semiconductor layer which is constituted by a first nitride semiconductor epitaxially grown in a c-axis direction and which is formed on the substrate having the first region and the second region;
a second semiconductor layer which is constituted by a second nitride semiconductor epitaxially grown in the c-axis direction and having different polarization, electron affinity, and band gap from the first nitride semiconductor, the second semiconductor layer being formed on the first semiconductor layer and forming a heterojunction with the first semiconductor layer;
a first field-effect-transistor of first electrical-conductivity type including a gate electrode, a source electrode, and a drain electrode and being formed in the first region; and
a second field-effect-transistor of second electrical-conductivity type including a gate electrode, a source electrode, and a drain electrode and being formed in the second region.

7. The semiconductor device according to claim 6, wherein
the polarity inversion layer is a layer made by nitriding aluminum oxide.

8. The semiconductor device according to claim 7, wherein
the polarity inversion layer is a layer made by nitriding a surface of the substrate made of sapphire.

9. The semiconductor device according to claim 7, wherein
the polarity inversion layer is a layer made by nitriding an oxidized surface of the substrate made of AlN and having Group-III polarity.

10. The semiconductor device according to claim 7, wherein
the polarity inversion layer is a layer made by nitriding an oxidized surface of a layer made of AlN and having Group-III polarity, formed on the substrate made of GaN and having Group-III polarity.

11. The semiconductor device according to claim 7, wherein
the polarity inversion layer is a layer made by nitriding an oxidized surface of a layer of Group-III-polar AlN formed on the substrate made of hexagonal SiC is nitrided.

12. The semiconductor device according to claim 6, wherein
the polarity inversion layer is a layer made by oxidizing aluminum nitride is oxidized.

13. The semiconductor device according to claim 12, wherein
the polarity inversion layer is a layer made by oxidizing a nitrided surface of the substrate made of sapphire.

14. The semiconductor device according to claim 12, wherein
the polarity inversion layer is a layer made by oxidizing a surface of the substrate made of AlN and having N-polarity.

15. The semiconductor device according to claim 12, wherein
the polarity inversion layer is a layer made by oxidizing a surface of a layer made of AlN, having N-polarity, and formed on the substrate made of GaN and having N-polarity.

16. The semiconductor device according to claim 12, wherein
the polarity inversion layer is a layer made by oxidizing a layer made of AlN, having N-polarity, and formed on the substrate made of hexagonal SiC having C-polarity.

17. The semiconductor device according to any one of claims 6 to 16, wherein
the first field-effect-transistor of p-type is formed in the first region, and
the second field-effect-transistor of n-type is formed in the second region.

18. The semiconductor device according to any one of claims 6 to 16, wherein
the first field-effect-transistor of n-type is formed in the first region, and
the second field-effect-transistor of p-type is formed in the second region.
